Europäisches Patentamt

European Patent Office

Office européen des brevets

(11) Numéro de publication: **0 021 879**
**A1**

## DEMANDE DE BREVET EUROPEEN

(21) Numéro de dépôt: 80400727.6

(22) Date de dépôt: 23.05.80

(51) Int. Cl.³: **H 01 L 41/08**
**G 01 L 1/16, G 01 L 9/08**

(30) Priorité: 13.06.79 FR 7915141

(43) Date de publication de la demande:
07.01.81 Bulletin 81/1

(84) Etats Contractants Désignés:
DE GB NL SE

(71) Demandeur: "THOMSON-CSF"
173, Boulevard Haussmann
F-75360 Paris Cedex 08(FR)

(72) Inventeur: Micheron, François
"THOMSON-CSF" SCPI 173, Bld Haussmann
F-75360 Paris Cedex 08(FR)

(74) Mandataire: Lepercque, Jean et al,
"THOMSON-CSF" - SCPI 173, Bld. Haussmann
F-75360 Paris Cedex 08(FR)

(54) Dispositif transducteur sensible à la pression à élément en polymère piézoélectrique, et son procédé de fabrication.

(57) L'invention se rapporte aux dispositifs transducteurs piézoélectriques sensibles à la pression comprenant un élément actif réalisé à partir d'un matériau polymère préalablement polarisé. Selon une première approche, le transducteur se présente sous la forme d'un câble multiconducteur, chaque conducteur (1, 2) formant une électrode et dont au moins un conducteur est noyé dans le matériau polymère (3) formant isolant.

Selon une seconde approche le transducteur se présente sous la forme d'un objet moulé, le matériau polymère (3) constituant le corps et dans lequel on a noyé des électrodes (1, 2).

L'invention s'applique notamment au domaine des capteurs de choc utilisés en chronométrie et aux hydrophones basse fréquence.

# DISPOSITIF TRANSDUCTEUR SENSIBLE A LA PRESSION A ELEMENT EN POLYMERE PIEZOELECTRIQUE ET SON PROCEDE DE FABRICATION

La présente invention se rapporte aux dispositifs transducteurs piézoélectriques dont l'élément actif est constitué par un matériau polymère qui, moyennant un traitement approprié, présente des propriétés piézoélectriques semblables à celles que possèdent les corps appartenant à certaines classes de cristaux. Les polymères dans lesquels on peut développer de tels effets sont nombreux, à titre indicatif on peut citer le polyfluorure de vinylidène ($PVF_2$), le polychlorure de vinyle (PVC), le polyfluorure de vinyle (PVF) ainsi que des copolymères, par exemple le polytétrafluorure éthylène-polyfluorure de vinylidène ($PTFE-PVF_2$).

Dans l'art connu, ces matériaux sont utilisés sous forme de films plans métallisés sur deux faces, qui ont été orientés mécaniquement ou non, et dans tous les cas polarisés par application de champ électrique intense (de l'ordre de 1 MV/cm), à température supérieure ou égale à la température ambiante. Grâce à ce traitement, les films en matériau polymère aquièrent des propriétés piézoélectriques permettant de les utiliser comme transducteurs. Comme applications de ces films plans, on peut citer des capteurs de pression et de déplacement (microphone, hydrophone, jauge de contrainte, etc...). Plus récemment, il a été proposé d'utiliser ces matériaux après thermoformage ou moulage selon des formes appropriées de façon à réaliser des membranes d'écouteurs, de haut-parleurs ou de microphones. De tels dispositifs transducteurs sont décrits, par exemple, dans la demande de brevet français N° 77.34 589, déposée le 17 Novembre 1977 au nom de la demanderesse et publiée sous le numéro 2 409 654.

La réalisation de ces transducteurs présente de nombreuses difficultés d'ordre technologique : problèmes d'enrobage, de sortie de fils de connexion, de dimensionnement d'autant plus difficiles à résoudre que le capteur est plus petit, et de métallisation pour constituer les électrodes. La dimension d'un capteur dépend beaucoup du type de mesure à effectuer : ponctuelle, intégrée sur une surface ; de sorte que chaque capteur doit être conçu en fonction de son utilisation propre. En outre, certains types de mesure nécessitent un très grand nombre de transducteurs.

Pour de nombreuses applications, il serait avantageux de pouvoir disposer de transducteurs bon marché et réalisés à partir d'éléments uniformisés, fabriqués en grande série et de façon continue.

Pour répondre à ces besoins, l'invention propose des dispositifs transducteurs ayant une structure analogue à celle des câbles électriques multiconducteurs et réalisés selon les mêmes techniques. Certaines variantes permettent également d'utiliser directement des câbles électriques comportant un isolant réalisée en matériau polymère et rendu actif par un traitement en tous points identique à celui mis en oeuvre pour rendre actif les feuilles polymères des matériaux transducteurs de l'art antérieur. L'invention propose également des dispositifs transducteurs moulés en mettant en oeuvre les techniques généralement utilisées pour produire des connecteurs.

L'invention à donc pour objet un dispositif transducteur sensible à la pression comprenant au moins deux électrodes conductrices et un élément en matériau polymère susceptible de présenter des propriétés piézoélectriques rendant actives au moins des régions du matériau polymère comprises entre les électrodes, par induction d'une anisotropie dans le matériau polymère à la suite d'un traitement approprié ; dispositif principalement caractérisé en ce qu'il se présente sous la configuration d'un câble d'une longueur prédéterminée comprenant plusieurs conducteurs dont au moins un est noyé dans le matériau polymère formant isolant ; chaque conducteur constituant une électrode et ces conducteurs étant dénudés en au moins une extrémité du câble de façon à pouvoir établir des liaisons électriques avec des circuits électroniques d'adaptation extérieurs.

L'invention a encore pour objet un procédé de fabrication d'un tel dispositif.

L'invention sera mieux comprise et d'autres avantages apparaîtront à la lecture de la description ci-après et à l'examen des figures annexées parmi lesquelles :

- la figure 1 illustre schématiquement un transducteur piézoélectrique de l'art connu.

- les figures 2 à 5 illustrent une première variante de dispositifs transducteurs selon l'invention.

- les figures 6 et 7 illustrent une seconde variante de transducteurs selon l'invention.

- les figures 9 et 10 illustrent une troisième variante de transducteurs selon l'invention.

- la figure 11 illustre une quatrième variante de transducteurs selon l'invention.

- les figures 12 et 13 illustrent une des phases du procédé de fabrication de dispositifs selon l'invention.

Dans ce qui suit, les éléments communs à deux ou plusieurs figures portent la même référence et ne seront décrits qu'une seule fois.

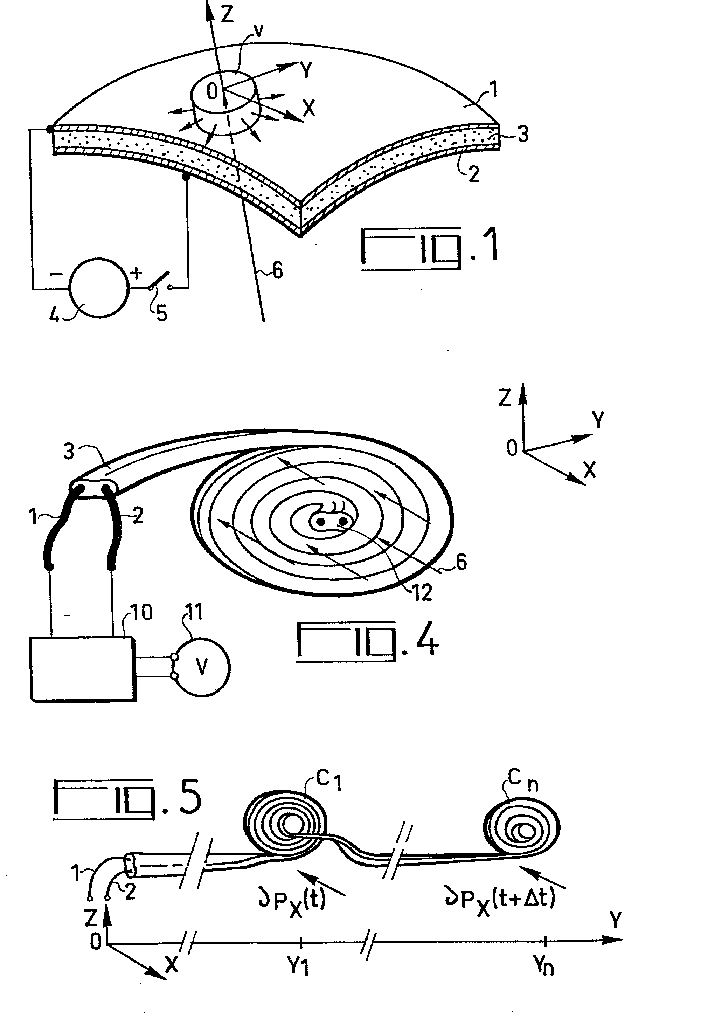

Un transducteur selon l'art ancien est illustré schématiquement sur la figure 1. Il se compose d'une feuille de matériau polymère 3 recouverte sur ses deux faces par les électrodes 1 et 2. On peut réaliser ces électrodes par métallisation de cette feuille 3. A titre d'exemple, ce matériau polymère peut être du polyfluorure de vinylidène ($PVF_2$). Comme il est bien connu, la structure du $PVF_2$ se compose de zones cristallines sphéroïdales contenues dans une phase amorphe. Les propriétés mécaniques macroscopiques sont celles d'un corps isotrope. Ce polymère présente trois formes cristallines distinctes $\alpha$, $\beta$ et $\gamma$. La forme $\alpha$ est celle que l'on obtient à partir du polymère fondu. Les chaînes moléculaires s'enroulent en hélice et présentent un agencement des atomes de carbone, d'hydrogène et de fluore, tel que les moments électriques dipolaires se compensent l'un l'autre lorsqu'on progresse le long de la chaîne. La forme $\beta$ et la forme $\gamma$, qui lui est similaire, sont moins stables que la forme et sont caractérisées par une chaîne en zig-zag et par des moments électriques dipolaires dont les effets s'ajoutent. Si on considère un petit élément volumique v du matériau polymère, cet élément comprend donc un certain nombre de chaînes représentant une phase solide I fortement polaire (phase $\beta$ et $\gamma$). Si le matériau polymère n'a subi aucune contrainte après solidification, il est doté d'une bonne stabilité mécanique et puisqu'il n'a pas été polarisé électriquement, on peut considérer que d'un point de vue macroscopique, il est électriquement isotrope. Il est également connu, que pour établir dans le polyfluorure de vinylidène ainsi que dans les autres polymères polaires des propriétés piézoélectriques, il faille soumettre

4

ces matériaux à un étirement important qui visent à convertir la phase II non polaire en phase I polaire. Cet étirement induit une anisotropie mécanique. Pour créer l'anisotropie électrique nécessaire à la manifestation des effets piézoélectriques, le matériau est soumis à un champ électrique de direction essentiellement orthogonale aux électrodes, c'est à dire sur la figure 1 de direction parallèle à l'axe Z. Ainsi traitée, la feuille en matériau polymère 3 forme un élément transducteur qui produit une tension électrique proportionnelle lorsqu'on l'échauffe ou lorsqu'on la soumet à une contrainte extérieure symbolisée par la flèche 6. A l'inverse, une tension électrique appliquée entre ces électrodes engendre des déformations mécaniques proportionnelles selon l'axe Z et dans le plan XY. Pour certains matériaux polymères, par exemple le polyfluorure de vinylidène, il est possible d'omettre la phase d'étirement mécanique et d'induire une anisotropie dans le matériau par voie purement électrique.

Les dispositifs réalisés à partir d'une feuille en matériau polymère active et comportant des électrodes déposées sur ses deux faces présentent cependant les inconvénients qui ont été rappelés précédemment.

Contrairement à l'art antérieur caractérisé en ce que les électrodes métalliques sont déposées sur la surface du matériau piézoélectrique, l'invention propose de noyer au moins une électrode dans ce matériau. Cette technique est compatible avec celle utilisée pour la tréfilerie des câbles multiconducteurs et permet de réaliser des dispositifs transducteurs bon marché, fabriqués en continu à la manière des câbles électriques multiconducteurs et comme eux, utilisés par tronçons.

L'exemple le plus simple que l'on peut donner est celui d'un câble bifilaire utilisé pour l'alimentation électrique des appareillages électriques de faible puissance dont l'isolant est choisi parmi la famille des polymères polaires cités précédemment ; les deux conducteurs constituant les électrodes du transducteur. Ce câble doit subir un traitement approprié pour rendre actif le matériau constituant l'isolant au moins dans les régions comprises entre les fils conducteurs. Ce traitement est en tous points identique à celui subi par le matériau polymère constituant l'élément actif des transducteurs de l'art connu. Une haute tension est appliquée entre les conducteurs, le câble étant placé dans une enceinte portée à une température suffisamment élevée, et pendant une durée assez longue pour que l'orientation dipolaire se produise dans l' isolant compris entre les deux conducteurs. Après refroidissement sous champ électrique, une longueur de câble est coupée à la longueur désirée pour réaliser un dispositif transducteur. Les conducteurs sont dénudés à une extrémité et constituent les deux fils de connexion du circuit de mesure.

Une telle structure constitue une première variante d'un dispositif transducteur selon l'invention. Elle va être décrite en relation avec les figures 2 à 5.

La figure 2 montre un fragment du câble bifilaire plat. Ce câble présente un plan de symétrie 9 parallèle aux deux conducteurs 1 et 2. Ces deux conducteurs sont enrobés par un isolant en matière plastique 3 et dans le cadre de l'invention, l'isolant 3 doit être réalisé en matériau polymère susceptible de présenter des propriétés piézoélectriques.

Pour induire ces propriétés dans le matériau de la gaine 3, on va relier les deux conducteurs 1 et 2 à une source d'énergie électrique 4 produisant une haute tension continue qui va être appliquée aux électrodes 1 et 2 pendant un temps suffisamment long, par l'intermédiaire du commutateur 5. Pendant tout ce temps, l'ensemble est placé dans une enceinte portée à une température élevée mais restant en-dessous du point de fusion du matériau de l' isolant 3. Il s'en suit qu'une orientation dipolaire est induite dans l' isolant, essentiellement dans la région comprise entre les deux conducteurs. Sur la figure 2, dans le plan de section 7, sont représentées schématiquement les lignes de force 8 en résultant. Le capteur élémentaire ainsi constitué est sensible essentiellement à des différences de pression exercées selon des directions parallèles à l'axe OX du trièdre de référence OXYZ. Pour augmenter cette sensibilité, on augmente la longueur du câble soumis à de telles pressions.

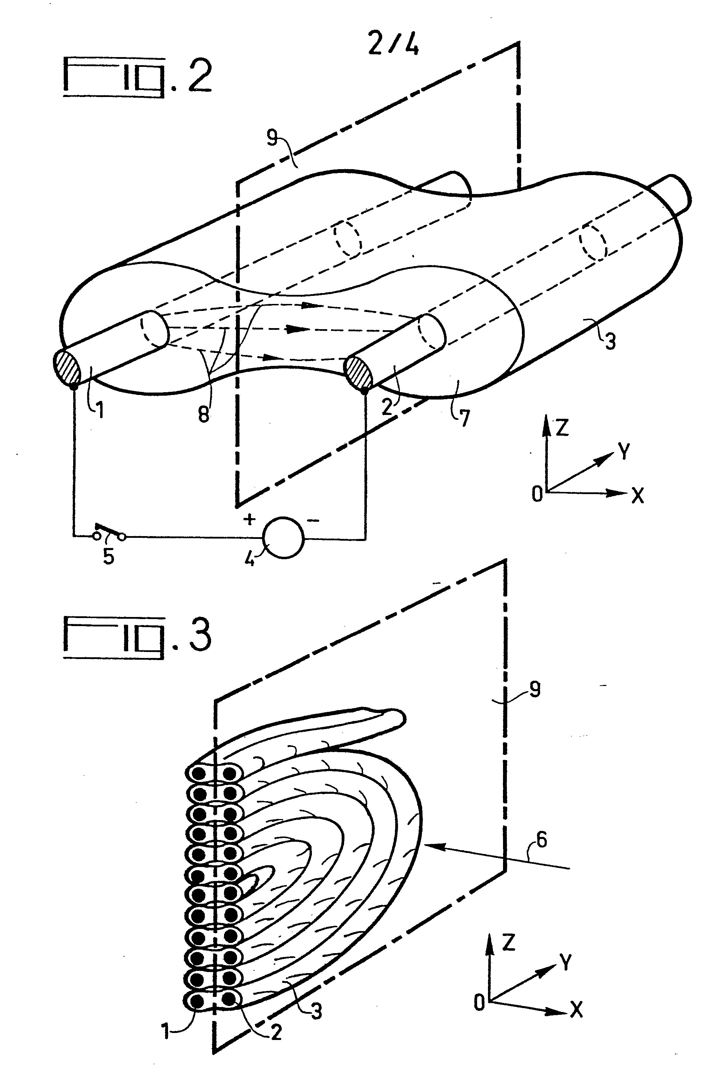

On peut utiliser cette variante de transducteur notamment pour des mesures de pression uniaxiales. Dans ce cas, pour augmenter la sensibilité, on enroule une longueur prédéterminée de câbles sous forme d'une spirale à spires jointives comme illustré sur la figure 3 en coupe. Cette spirale conserve le même plan de symétrie 9. Le capteur ainsi constitué est essentiellement sensible à des pressions suivant la direction de la flèche 6, parallèle à l'axe OX.

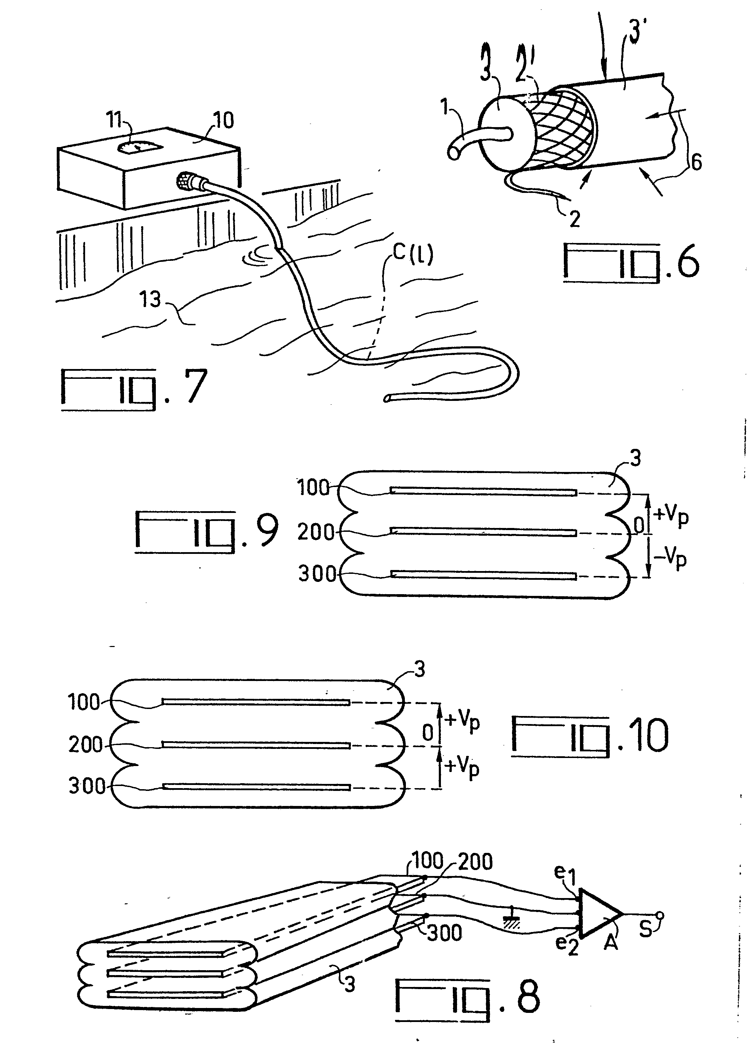

Une des extrémités du câble comme illustrée sur la figure 4 est dénudée et les conducteurs 1 et 2 sont reliés à des circuits électroniques 10 d'adaptation et éventuellement d'amplification des signaux électriques recueillis aux bornes de ces conducteurs. Ces circuits électroniques 10 sont eux-mêmes reliés à un appareil de mesure 11 pouvant être indifféremment à affichage analogique ou numérique. L'extrémité 12 du capteur peut être rendue électriquement isolante, par exemple en portant localement l'isolant à l'état de fusion, pour recouvrir l'extrémité des conducteurs 1 et 2.

Un capteur de pression réalisé selon la variante qui vient d'être décrite a été expérimenté. Pour ce faire, on a enroulé une longueur de 1 m de câble bifilaire comportant deux conducteurs de cuivre tressés, de section 1,5 mm$^2$, enrobés dans du polychlorure de vinylidène. Cette spirale a été maintenue en place à l'aide d'un adhésif résistant aux hautes températures. Elle a été ensuite placée dans une enceinte portée à une température de 100° C et les conducteurs ont été reliés à un générateur d'énergie électrique délivrant une tension de 7 KV. Cette polarisation a été maintenue pendant deux heures, puis la température a été ramenée à la température ambiante en l'espace d'une demi heure (la tension électrique de 7 KV étant maintenue).

La spirale étant placée à plat sur un plan, un poids de 1 Kg déposé sur la spirale génère une tension de 50 mV entre les conducteurs 1 et 2.

Ceci correspond à un coefficient piézoélectrique apparent plus faible que celui mesuré sur du polychlorure de vinyle pur. La différence entre ces deux coefficients a essentiellement pour origine le plastifiant habituellement introduit dans la gaine du câble, plastifiant mélangé avec le polychlorure de vinyle qui diminue la concentration en dipôles et peut inhiber de ce fait l'orientation dipolaire.

Il est courant en câblerie d'utiliser d'autres polymères que le PVC et en particulier le copolymère PVF$_2$-PTFE connu sous la marque "Kynar 7200" de la firme PENNWALT ou le PVF$_2$ connu sous les marques "FORAFLON" de la firme PECHINEY UGINE KULMANN ou "SOLEF" de la firme SOLVAY. Les coefficients piézoélectriques de ces polymères, polarisés après avoir été fondus sont d'un ordre supérieur à ceux du PVC.

L'invention permet donc de réaliser des capteurs très bon marché, de façon simple et à partir d'éléments uniformisés, c'est à dire de câbles électriques bifilaires plats coupés à la longueur désirée. Ces câbles étant destinés à la réalisation de connexions pour des appareillages électriques ne présentent pas des caractéristiques optimisées en vue de la fabrication de transducteurs selon l'invention. On peut fabriquer de tels câbles plus spécifiquement, ce sans diminuer les avantages apportés par l'invention, en choisissant notamment un matériau polymère plus adapté à l'application envisagée. On utilise alors les mêmes techniques que celles de la tréfilerie classique. Il est à remarquer que dans tous les cas, lors de la fabrication du câble, le matériau constituant l' isolant (c'est à dire le matériau polymère 3) est soumis à une orientation en milieu liquide, ce qui permet d'utiliser tous les polymères polaires et non uniquement les polymères dans lesquels une anisotropie est suceptible d'être induite par la seule voie électrique.

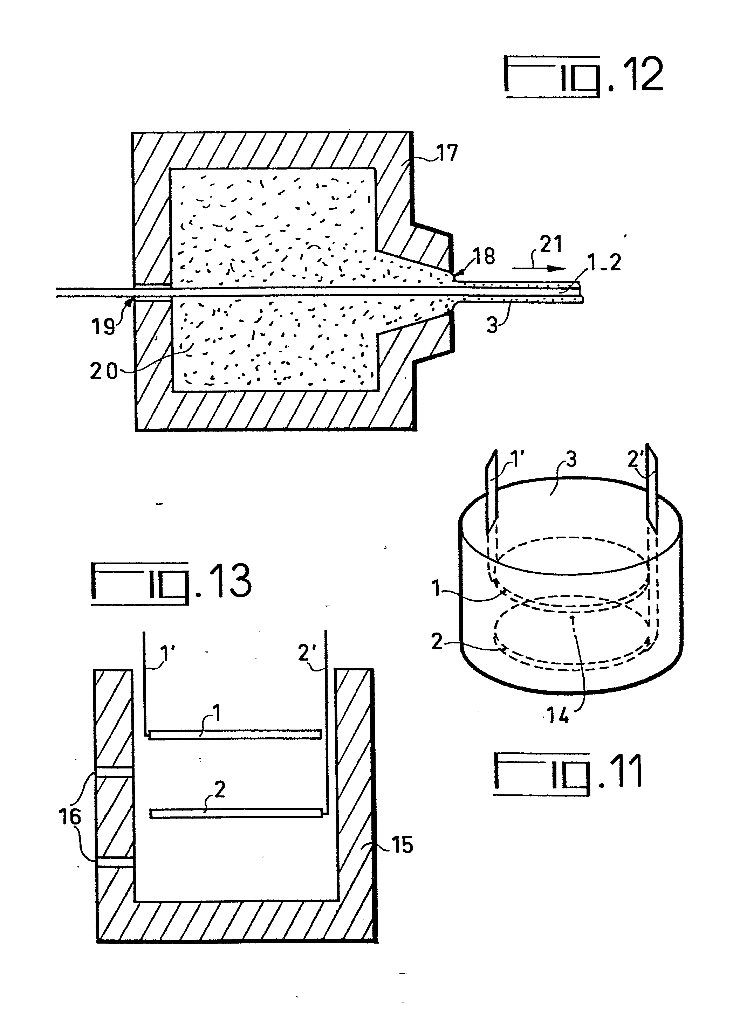

En effet, si on se reporte à la figure 12 schématisant une filière, les conducteurs 1 et 2 sont introduits par un orifice 19 percé dans l'enceinte de la filière 17 contenant le matériau polymère destiné à l'enrobage. Ce matériau et les conducteurs ressortent par un orifice conique 18. Le mouvement se fait suivant la direction de la flèche 21. Selon les dimensions de l'orifice 18 et les conditions d'extrusion, le matériau 20 destiné à constituer l' isolant 3 est étiré de façon variable selon des coefficients variant de 100 % à 300 % environ.

Enfin le câble peut n'être activé que sur certaines portions prédéterminées : on peut supprimer la polarisation induite dans les portions non désirées en portant le matériau polymère des régions concernées à l'état de fusion.

Des capteurs de pression, tels qu'illustrés par la figure 4, peuvent être disposés sur une ligne de type omnibus. On peut notamment prolonger le câble en son extrémité 12 en le ressortant de la spirale et ainsi, comme illustré par la figure 5, constituer un système de capteurs de pression $C_1$ à $C_n$ régulièrement espacés le long d'une ligne omnibus bifilaire.

Un tel système peut être utilisé pour mesurer les ondes de pression produites par un objet se déplaçant le long d'un axe et par exemple le long de l'axe OY. A l'instant t, la position de l'objet sera $Y_1$ et à l'instant $t + \Delta t$ :

$Y_n$. La tension développée entre les bornes des conducteurs 1 et 2 sera proportionnelle respectivement à $\partial P_X(t)$ et $\partial P_X(t + \Delta t)$. Ceci constitue un exemple d'application non limitatif d'une première variante de dispositifs selon l'invention.

Une seconde variante de dispositifs transducteurs selon l'invention est illustrée en relation avec la figure 6.

On peut en effet également utiliser à la place de câbles bifilaires, un câble coaxial comportant une âme en cuivre 1 entourée d'un isolant diélectrique 3 et d'une tresse 2'. Une enveloppe extérieure 3' peut être prévue et sert notamment à l'isolation électrique ainsi qu'à la protection du câble contre les agressions extérieures. La tresse 2' peut être soudée à une extrémité à un conducteur 2. Un transducteur réalisé à l'aide d'un tel câble et soumis au traitement qui a été décrit peut être utilisé comme capteur de pression et notamment pour la mesure de pression hydrostatique, car il est sensible à des pressions dirigées radialement comme indiqué par les flèches 6. Il est à noter que la gaine 3' ne joue aucun rôle transducteur, seule la région 3 est rendue active.

La figure 7 illustre schématiquement l'application d'un tel capteur à des mesures de pression hydrostatiques. Le câble coaxial d'une longueur l réalise un capteur C (l) pouvant être plongé dans un milieu liquide 13 et relié à un appareil de mesure 10-11. On peut ainsi tapisser une surface entière de ce câble, la pression mesurée étant proportionnelle à la longueur totale du capteur, c'est à dire à la longueur totale du câble coaxial. Une configuration coaxiale présente également l'avantage sur une configuration bifilaire de posséder un écran électrostatique constitué par la tresse 2' entourant le conducteur central et minimisant la collection de rayonnements électromagnétiques susceptibles d'induire une tension parasite dans les conducteurs 1 et 2 et d'altérer les mesures.

Il est également possible d'utiliser des câbles possédant plus de deux conducteurs et notamment un nombre impair de conducteurs, par exemple trois comme illustré sur la figure 8 : les conducteurs 100, 200 et 300, noyés dans l'isolant 3 en matériau polymère, doivent se présenter de préférence sous la forme d'un ruban de façon à rendre maximales les surfaces de ces conducteurs en vis à vis. On fait subir à ce câble le même traitement que précédemment décrit. On peut polariser les électrodes deux à deux à l'aide de sources d'énergie électrique de polarités opposées telles que représentées sur la figure 9. La paire d'électrodes 100 et 200 est polarisée à l'aide d'une tension $+V_p$ et la paire d'électrodes 200 et 300 à l'aide d'une tension $V_p$, l'électrode 200 étant supposée reliée à la masse, c'est à dire à un potentiel 0. Les électrodes 100 et 300 sont reliées aux entrées $e_1$ et $e_2$ d'un amplificateur différentiel A. Si on soumet le câble ainsi polarisé à une compression selon un axe perpendiculaire à la surface des électrodes, la tension qui se développe entre les électrodes 100 et 300 est sensiblement nulle. Par contre, si ce même câble est soumis à une flexion, la tension recueillie entre les électrodes 100 et 300 n'est plus nulle et représente l'intensité de cette flexion, tension après amplification recueillie sur la sortie S de l'amplificateur différentiel A.

Si maintenant les paires d'électrodes 100-200 et 200-300 sont polarisées avec une tension $+V_p$ de même polarité comme indiquée sur la figure 10, le câble sera sensible, non plus à la flexion, mais à la compression.

Ces deux modes de fonctionnement dépendent également de la nature des bornes d'entrée de l'amplificateur A. Selon que ces entrées sont additives ou soustratives, on peut avec les capteurs polarisés selon les schémas des figures 9 et 10 réaliser les fonctions inverses de ce qui vient d'être décrit.

Enfin, sans quitter le cadre de l'invention, on peut réaliser des dispositifs transducteurs à électrodes noyées ne présentant pas sous la forme de câbles. Dans ce cas, on peut utiliser les techniques mises en oeuvre pour la fabrication de connecteurs électriques et réaliser des dispositifs transducteurs moulés dans la masse.

Des formes quelconques de dispositifs transducteurs peuvent être obtenues par injection de polymère dans un moule, dans lequel sont disposées des électrodes maintenues en relation spatiale prédéterminée. La technique proposée se rapproche de celle mise en oeuvre pour la fabrication de connecteurs électriques, dont les matériaux isolants seraient choisis parmi les polymères polaires, rendus actifs par le traitement décrit précédemment. L'exemple le plus simple d'un capteur selon cette quatrième variante est représenté sur la figure 11. Il comprend deux électrodes planes circulaires 1 et 2, délimitant une région 14 susceptible d'être rendue active, d'une masse de matériau polymère 3 noyant ces électrodes. Des connexions 1' et 2' sortent par la face supérieure de ce dispositif. La figure 13 illustre schématiquement le procédé de fabrication. Le moule 15 comporte deux orifices 16 par lesquels on introduit le matériau polymère par injection à l'état pâteux. Les deux électrodes 1 et 2 peuvent être maintenues simplement par la seule rigidité mécanique des connexions 1' et 2'.

Dans une version industrielle, l'ensemble peut se présenter sous une forme analogue à une fiche électrique, mâle ou femelle, surmoulée.

Le matériau polymère peut être également introduit dans le moule sous forme pulvérulente et porté à une température telle (et sous pression) que le matériau entre en fusion.

Dans cette variante, il est particulièrement intéressant d'utiliser les matériaux polymères pour lesquels on peut obtenir des effets piézoélectriques par voie purement électrique.

Cette variante de réalisation peut être mise en oeuvre comme capteur de choc en chronométrie.

L'invention n'est pas limitée aux exemples de réalisation qui viennent d'être décrits, ni aux exemples d'application des dispositifs transducteurs ainsi réalisés

Le matériau polymère peut être choisi parmi les polymères suivants : polychlorure de vinyle, polyfluorure de vinyle, polyfluorure de vinylidène, polychlorotrifluoéthylène, ou encore les copolymères suivants : polyfluorure de vinyle – polytétrafluorure d'éthylène, polyfluorure de vinyle-polyfluorure de vinylidène ou un polyéthylène chloré ayant pour constituants le polyéthylène, le chlorure de polyvinyle et le polychlorure de vynilidène.

11

## REVENDICATIONS

1. Dispositif transducteur sensible à la pression comprenant au moins deux électrodes conductrices et un élément en matériau polymère susceptible de présenter des propriétés piézoélectriques rendant actives au moins des régions du matériau polymère comprises entre les électrodes, par induction d'une anisotropie dans le matériau polymère à la suite d'un traitement approprié ; dispositif caractérisé en ce qu'il se présente sous la configuration d'un câble d'une longueur prédéterminée comprenant plusieurs conducteurs (1, 2) dont au moins un est noyé dans le matériau polymère (3) formant isolant ; chaque conducteur constituant une électrode et ces conducteurs étant dénudés en au moins une extrémité du câble de façon à pouvoir établir des liaisons électriques avec des circuits électroniques d'adaptation extérieurs (10).

2. Dispositif selon la revendication 1, caractérisé en ce que le câble est un câble plat comprenand deux conducteurs (1, 2) constituant chacun une électrode noyée dans le matériau polymère (3) formant isolant, le matériau polymère étant rendu actif dans une région comprise essentiellement entre les deux conducteurs pour présenter des orientations dipolaires suivant des lignes de force (8) reliant les deux conducteurs électriques et situés dans des plans (7) orthogonaux à ces conducteurs.

3. Dispositif selon la revendication 2, caractérisé en ce qu'en outre le câble est enroulé sur lui-même de façon à ce que chacun des deux conducteurs (1, 2) forme une spirale ; les spirales étant contenues dans deux surfaces parallèles.

4. Dispositif selon la revendication 1, caractérisé en ce que le câble comprend un nombre impair de conducteurs se présentant sous la forme de rubans métalliques (100, 200, 300), parallèles entre eux, constituant chacune une électrode ; et en ce que les régions en matériau polymère comprises entre les plans formés par les rubans métalliques sont rendues actives de manière à présenter des orientations dipolaires suivant des lignes de force essentiellement orthogonales au plan des rubans et de sens contraire d'une région à la suivante.

5. Dispositif selon la revendication 1, caractérisé en ce que le câble comprend un nombre impair de conducteurs se présentant sous la forme de rubans métalliques (100, 200, 300), parallèles entre eux, chaque ruban constituant une électrode ; et en ce que les régions comprises entre les plans formés par les rubans métalliques sont rendues actives de manière à présenter des orientations dipolaires suivant des lignes de force essentiellement orthogonales au plan des rubans et de même sens d'une région à la suivante.

6. Dispositif selon la revendication 1, caractérisé en ce qu'il se présente sous la configuration d'un câble coaxial comprenant un conducteur électrique central (1) noyé dans le matériau polymère (3) et une tresse conductrice périphérique (2') ; et en ce que le conducteur central (1) et la tresse conductrice périphérique (2') formant chacune une électrode, le matériau polymère (3) est rendu actif pour présenter des orientations dipolaires suivant des lignes de force orthogonales au conducteur central.

7. Dispositif transducteur comprenant deux électrodes conductrices (1, 2) placées en vis-à-vis et un élément en matériau polymère susceptible de présenter des propriétés piézoélectriques rendant actives au moins la région (14) du matériau polymère comprises entre les deux électrodes par induction d'une anisotropie à la suite d'un traitement approprié ; dispositif caractérisé en ce qu'il se présente sous la configuration d'un objet moulé, l'une au moins des deux électrodes étant noyées dans un matériau polymère (3) constituant le corps du dispositif et la région (14) comprise entre les deux électrodes (1, 2) rendue active présentant une orientation dipolaire suivant des ligne de force essentiellement orthogonales aux surfaces des électrodes ; des conducteurs électriques (1', 2') prolongeant les électrodes assurant en outre des liaisons électriques avec l'extérieur du dispositif.

8. Dispositif selon l'une quelconque des revendications 1 à 7, caractérisé en ce que le matériau polymère est choisi parmi les polymères suivants : polychlorure de vinyle, polyfluorure de vinyle, polyfluorure de vinylidène, polychlorotrifluoéthylène, ou les copolymères suivants : polyfluorure de vinyle - polytétrafluorure d'éthylène, polyfluorure de vinyle-polyfluorure de vinylidène ou un polyéthylène chloré ayant pour constituants le polyéthylène, le chlorure de polyvinyle et le polychlorure de vynilidène.

9. Procédé de fabrication d'un dispositif selon l'une quelconque des revendications 1 à 8, caractérisé en ce que le traitement approprié visant à rendre actives au moins les régions du matériau polymère comprises entre les électrodes comprend au moins une phase de polarisation électrique de ces régions ; cette polarisation étant réalisée en reliant les électrodes deux à deux à un générateur d'énergie électrique (4) délivrant une haute tension continue pendant un temps prédéterminé suffisant pour induire de façon permanente dans les régions rendues ainsi actives, une anisotropie résultant d'une orientation dipolaire suivant des lignes de force (8) essentiellement normales aux électrodes (1, 2) et communiquant à ces régions des propriétés piézoélectriques.

10. Procédé selon la revendication 9, caractérisé en ce que le dispositif comprenant un nombre impair d'électrodes (100, 200, 300), les électrodes délimitant des régions successives sont reliées deux à deux à des générateurs d'énergie électrique délivrant une tension continue de polarité opposée (+ $V_p$, - $V_p$).

11. Procédé selon la revendication 9, caractérisé en ce que le dispositif comprenant un nombre impair d'électrodes (100, 200, 300), les électrodes délimitant des régions successives sont reliées deux à deux à des générateurs d'énergie électrique délivrant une tension continue de même polarité (+ $V_p$).

12. Procédé selon la revendication 9, caractérisé en ce que, le dispositif étant réalisé à partir d'un câble électrique plat comprenant deux conducteurs (1, 2) noyés dans un matériau polymère (3) formant gaine, ce matériau subit lors de la réalisation du câble un étirement mécanique contrôlable (21) pendant la phase d'enrobage des conducteurs par la matériau et en ce que le câble est ensuite enroulé en spirale après section d'une longueur prédéterminée de câble, cette spirale étant maintenue par collage à l'aide d'un adhésif.

13. Procédé selon la revendication 9, caractérisé en ce que, le dispositif se présentant sous la forme d'un objet moulé, le matériau polymère est introduit dans l'enceinte intérieure d'un moule (15) ; des électrodes (1, 2) étant disposées au préalable dans l'enceinte en relation spatiale prédéterminée.

14. Procédé selon la revendication 13, caractérisé en ce que l'introduction dans l'enceinte du moule (15) se fait par injection de matériau polymère à l'état pâteux ou par remplissage à l'état pulvérulent ; l'enceinte intérieure du moule étant en outre mis ultérieurement sous pression et portée à une température telle que le matériau à l'état pulvérulent entre en fusion.

FIG.1

FIG.4

FIG.5

Fig. 2

9

3

1

8

2

7

5    4

+    −

Z
Y
0    X

Fig. 3

9

6

1

2    3

Z
Y
0    X

$\text{F}\square.6$

$\text{F}\square.7$

$\text{F}\square.9$

$\text{F}\square.10$

$\text{F}\square.8$

Fig.12

Fig.13

Fig.11

0021879

Numéro de la demande

EP 80 40 0727

**Office européen des brevets**

## RAPPORT DE RECHERCHE EUROPEENNE

| | DOCUMENTS CONSIDERES COMME PERTINENTS | | CLASSEMENT DE LA DEMANDE (Int. Cl. 3) |
|---|---|---|---|
| Catégorie | Citation du document avec indication, en cas de besoin, des parties pertinentes | Revendication concernée | |
| | US - A - 3 110 824 (EASTMAN KODAK)<br>* Colonne 2, lignes 11-26; figure 1 *<br><br>-- | 1 | H 01 L 41/08<br>G 01 L 1/16<br>9/08 |
| | FR - A - 2 117 315 (KUREMA KAGAKU KOGYO KABUSHIKI KAISHA)<br>* Page 3-6 *<br><br>-- | 1,5-9 | |
| | FR - A - 2 233 615 (GENERAL DYNAMICS)<br>* Revendications 1,2 *<br><br>---- | 1 | **DOMAINES TECHNIQUES RECHERCHES (Int. Cl. 3)**<br><br>H 01 L 41/08<br>41/18<br>G 01 L 1/16<br>9/08 |

**CATEGORIE DES DOCUMENTS CITES**

X: particulièrement pertinent

A: arrière-plan technologique

O: divulgation non-écrite

P: document intercalaire

T: théorie ou principe à la base de l'invention

E: demande faisant interférence

D: document cité dans la demande

L: document cité pour d'autres raisons

&: membre de la même famille, document correspondant

Le présent rapport de recherche a été établi pour toutes les revendications

| Lieu de la recherche | Date d'achèvement de la recherche | Examinateur |
|---|---|---|
| La Haye | 19-09-1980 | PELSERS |

OEB Form 1503.1 06.78